# EUROPÄISCHE PATENTSCHRIFT

(11) **EP 0 991 791 B1**
(45) Veröffentlichungstag und Bekanntmachung des Hinweises auf die Patenterteilung: **22.01.2003**
(21) Anmeldenummer: 98916790.3
(22) Anmeldetag: 14.05.1998
(51) Int. Cl.: C23C 14/10, G02B 5/28, C23C 28/00

(54) **VERPACKUNGSMATERIAL**
PACKAGING MATERIAL
MATERIEL D'EMBALLAGE

(30) Priorität: 21.05.1997 EP 97810313
(43) Veröffentlichungstag der Anmeldung: 12.04.2000
(60) Teilanmeldung: 02003382.5
(73) Patentinhaber: Alcan Technology & Management AG, 8212 Neuhausen am Rheinfall (CH)
(72) Erfinder: LOHWASSER, Wolfgang, D-78262 Gailingen (DE); ZEITER, Patrik, CH-8044 Zürich (CH)
(86) Internationale Anmeldenummer: CH9800200
(87) Internationale Veröffentlichungsnummer: WO98053115

(56) Entgegenhaltungen:
- DE-A- 4 438 608
- DE-C- 4 305 856
- US-A- 3 858 977
- US-A- 4 779 898
- US-A- 5 059 245
- US-A- 5 437 931
- DATABASE WPI Section Ch, Week 9548 Derwent Publications Ltd., London, GB; Class F06, AN 95-371518 XP002043561 & JP 07 252 773 A (OIKE KOGYO KK) , 3. Oktober 1995

## Beschreibung

Vorliegende Erfindung betrifft ein Verfahren zur Herstellung von Verpackungsmaterialien oder Packhilfsmittel gemäss dem Oberbegriff des Anspruchs 1.

Es ist bekannt durch Hologramme, Farbcodierungen oder unsichtbare Merkmale Verpackungen oder Packungshilfsmittel fälschungssicher zu machen. Um erkennbar zu machen, dass eine Verpackung -- erlaubter- oder unerlaubterweise -- bereits geöffnet worden ist, werden Verpackungen mit einer Erstöffnungsgarantie ausgestattet. Die Originalitätsgarantie ermöglicht dem Kunden zu erkennen, dass das erworbene Produkt tatsächlich von gewünschten Produzenten hergestellt und verpackt worden ist und es sich nicht um eine Imitation oder Fälschung handelt. Die Erstöffnungsgarantie kann beispielsweise ein Packhilfsmittel in Form einer Etikette, einer Banderole oder eines Siegelstreifens usw. sein, die z.B. über einem Flaschenverschluss oder über dem Verschluss eines Weithalsglases, über der Naht zwischen einem Deckel und einem Behälter oder über dem Aufreissverschluss eines Beutels festgelegt worden ist. Beim Öffnen der entsprechenden Packung wird die Etikette, Banderole oder Siegelstreifen zerstört und damit angezeigt, dass eine Erstöffnung bereits erfolgt ist. Es ist auch möglich, Gegenstände in eine Umverpackung zu füllen oder einzuhüllen, wobei die Umverpackung charakteristische unverwechselbare und nicht kopierbare Merkmale aufweist, welche zeigen, dass das Verpacken des Inhaltes bei einem bestimmten Lieferanten erfolgte.

In der Praxis haben zu den genannten Zwecken beispielsweise Hologramme eingang gefunden. Beispiele sind Hologrammetiketten oder Deckelfolien mit integrierten Hologrammen. Die Erzeugung von Hologrammen stellt aber ein enormer Aufwand dar.

Die US 5,437,931 beschreibt die Herstellung eines Vielschichtfilmes mit einem symmetrischen Schichtaufbau, welcher optisch variable Eigenschaften aufweist. Der Vielschichtfilm enthält eine zentrale, opake Metallschicht mit einer Schichtdicke von z.B. 80 nm und beidseitig auf der opaken Metallschicht angeordnet eine Schicht aus SiO₂ mit einer Schichtdicke von z.B. 186 nm. Auf der SiO₂ -Schicht ist beidseitig eine für sichtbares Licht semitransparente Metallschicht mit einer Dicke von z.B. 6 nm angeordnet. Der Vielschichtfilm wird über eine Trennschicht ablösbar auf ein Substrat abgeschieden. Aus dem Vielschichtfilm werden flockenförmige Pigmente hergestellt, die ihrerseits in eine Matrix aus einem Lack oder Kunststoffharz eingemischt und auf ein Verpackungssubstrat aufgetragen werden.

Die Pigmente mit ihren optischen Effekten können z.B. die Funktion eines Fälschungsschutzes übernehmen.

Die DE 43 05 856 C1 beschreibt ein Verfahren zur Herstellung einer Barriereschicht auf Verpackungsfolien, hergestellt durch Verdampfen von einem im Vakuum verdampfbaren Aufdampfgut, wobei die Barriereschicht Silicium und Sauerstoff und Bor enthält.

In Anbetracht dessen, dass es sich bei den Verpackungen oder Packhilfsmittel um Gegenstände zum kurzzeitigen und einmaligen Gebrauch handelt, ist das Bestreben da, fälschungssichere Verpackungen oder Packhilfsmittel zu schaffen, die auf kostengünstige Weise hergestellt, jedoch nicht auf einfache Weise gefälscht werden können.

Erfindungsgemäss wird dies durch die Merkmale des kennzeichnenden Teils des Anspruchs 1 erreicht.

Auf dem beschichteten Substrat auftreffendes Licht wird reflektiert und das reflektierte Licht wird je nach Betrachtungsrichtung oder -winkel in unterschiedlichen Farben wahrgenommen.

Die integrierte Erstöffnungs- und/oder Orginalitätsgarantie an den Verpackungen oder Packhilfsmitteln nach vorliegender Erfindung ist für einen Betrachter bei Tages- oder Kunstlicht immer, unmittelbar und ohne apparative Hilfe erkennbar. Je nach Betrachtungsrichtung oder -winkel der Verpackung oder des Packhilfsmittels ändert sich die wahrgenommene Farbe oder Farbschattierung für den Betrachter.

Das eingesetzte Substrat kann beispielsweise ein beliebiges Verpackungsmaterial sein. Das Verpackungsmaterial kann starr, halbstarr oder flexibel sein und kann ein Formkörper oder insbesondere ein folienförmiges Material darstellen. Beispiele für Formkörper sind geblasene, tief- und/oder streckgezogene oder getiefte Formkörper, wie Flaschen, Weithalsgefässe, Becher. Schalen oder Bodenteile von Durchdrückpackungen oder Blisterpackungen. Beispiele für folienförmige Materialien sind Metallfolien, wie Aluminium-, Stahl-, Kupfer-, Silber- oder Goldfolien. Weitere Beispiele für folienförmige Materialien sind Papiere, wie Seidenpapier mit einem Flächengewicht von 20 bis 30 g/m² oder Hochweisspapiere mit einem Flächengewicht von 40 bis 60 g/m², Karton, Halbkarton od. dergl. Bedeutsam sind insbesondere kunststoffhaltige Folien, z.B. auf Basis von Palyolefinen, wie Polyethylenen oder Polypropylenen, Polyamiden, Polyvinylchlorid, Polyestern, wie Polyalkylenterephthaläten und insbesondere Polyethylenterephthalat. Die kunststoffhaltigen Folien können Monofolien aus Kunststoffen, Laminate aus zwei oder mehreren Kunststofffolien, Laminate aus Metall- und Kunststofffolien, Laminate aus Papieren und Kunststofffolien oder Laminate aus Papieren und Metall- und Kunststofffolien sein. Die einzelnen Kunststofffolien können eine Dicke von beispielsweise 12 bis 150 µm und die Metallfolien von 12 bis 100 µm aufweisen. Als Substrate zu erwähnen sind schliesslich auch Laminate aus Papieren, Halbkarton, Karton und Metallfolien. Die einzelnen Schichten der folienförmigen Materialien können mittels Klebstoffen, Kaschierklebern, Haftvermittlern und/oder durch Extrusionsbeschichten, Coextrusion oder Kaschieren usw. aneinander festgelegt werden.

Als Substrate sind bevorzugt nicht orientierte oder axial oder biaxial orientierte Monofolien oder Laminate aus zwei oder mehreren nicht orientierten oder axial oder biaxial orientierten Folien aus Kunststoffen auf Basis von Polyolefinen, wie Polyethylenen oder Polypropylenen, Polyamiden, Polyvinylchlorid, Polyestern, wie Polyalkylentereghthalaten und insbesondere Polyethylenterephthalat. Beispielsweise können Monofolien als Basissubstrat mit den erfindungsgemässen Schichten versehen werden und in weiteren anschliessenden Verarbeitungsschritten kann die Monofolie mit weiteren Materiallagen zum endgültigen Substrat aufgebaut werden.

Weitere typische Beispiele von Substraten weisen folgenden Schichtaufbau auf:
a) eine erste Schicht enthaltend eine nicht orientierte, axial oder biaxial orientierte Monofolie oder ein Laminat aus zwei oder mehreren nicht orientierten, axial oder biaxial orientierten Folien aus Kunststoffen auf Basis von Polyolefinen, wie Polyethylenen oder Polypropylenen, Polyamiden, Polyvinylchlorid, Polyestern, wie Polyalkylenterephthalaten und insbesondere Polyethylenterephthalat, und/oder ein Papier, wie ein Seidenpapier mit einem Flächengewicht von 20 bis 30 g/m² oder ein Hochweisspapier mit einem Flächengewicht von 40 bis 60 g/m², oder einen Schutzlack,
b) eine zweite Schicht, wie eine Metallfolie und insbesondere eine Aluminiumfolie,
c) eine dritte Schicht in der Form eines Auftrages eines Heissiegellackes:
oder
a) die erste Schicht, wie oben beschrieben,
b) die zweite Schicht, wie oben beschrieben,
c) eine dritte Schicht aus einer nicht orientierten, axial oder biaxial orientierten Monofolie oder einem Laminat aus zwei oder mehreren nicht orientierten, axial oder biaxial orientierten Folien aus Kunststoffen auf Basis von Polyolefinen, wie Polyethylenen oder Polypropylenen, Polyamiden, Polyvinylchlorid, Polyestern, wie Polyalkylenterephthalaten und insbesondere Polyethylenterephthalat, oder einer gegossenen Polyethylenbeschichtung;
oder
a) diese Schicht wird weggelassen.
b) eine erste Schicht, wie eine Metallfolie und insbesondere eine Aluminiumfolie,
c) eine zweite Schicht enthaltend eine nicht orientierte, axial oder biaxial orientierte Monofolie oder ein Laminat aus zwei oder mehreren nicht orientierten, axial oder biaxial orientierten Folien aus Kunststoffen auf Basis von Polyolefinen, wie Polyethylenen oder Polypropylenen, Polyamiden, Polyvinylchlorid, Polyestern, wie Polyalkylenterephthalaten und insbesondere Polyethylenterephthalat, und/oder ein Papier, wie ein Seidenpapier mit einem Flächengewicht von 20 bis 30 g/m² oder ein Hochweisspapier mit einem Flächengewicht von 40 bis 60 g/m², oder einen Schutzlack.

In der Regel ist die erste Schicht a) gegen die Aussenseite einer Verpackung gerichtet oder stellt die nach aussen gerichtete Seite des Packhilfsmittels dar. Dementsprechend wird sinngemäss auf der freien Oberfläche der Schicht a) die reflektierende Oberfläche angeordnet oder die freie Seite der Schicht b) stellt die reflektierende Oberfläche dar. Bei der Verwendung vorliegenden Verpackungsmaterials z.B. als Deckelmaterial für die Abdeckung von durchsichtigen Behältern, wie durchsichtigen Bodenteilen von Blisterpackungen oder von durchsichtigen Bechern od. dergl., kann eine reflektierende Oberfläche und die darauf angebrachte erfindungsgemässe Schichtfolge gegen die Innenseite der Verpackung gerichtet und durch den durchsichtigen Bodenteil, Becher od. dergl. sichtbar sein.

Das Substrat muss die aussenliegende das sichtbare Licht reflektierende Oberfläche aufweisen. Deshalb ist es erforderlich, dass beispielsweise die Papiere, der Karton oder Halbkarton, die Monofolien oder die Laminate mit aussenliegenden Kunststoffschichten eine reflektierende Oberflächenschicht erhalten. Bei Metallfolien kann die reflektierende Schicht die Metallfolie selbst sein. Metallfolien können als reflektierende Schicht bereits eine glänzende bis hochglänzende Oberfläche aufweisen. Ist am Substrat eine solche Metallfolie nicht vorhanden oder ist die Metallfolie zwischen anderen Schichten eingebettet oder ist das Reflexionsvermögen einer Metallfolie ungenügend, kann auf dem Substrat eine reflektierende Schicht, beipielsweise durch chemische, nasschemische oder physikalische Abscheidung eines Metalles, aufgebracht werden. Das Aufbringen des Metalles kann durch Metallisieren der Oberfläche, vorzugsweise durch ein Vakuumdünnschichtverfahren, wie die sogenannte "chemical vapor deposition" (CVD) oder "physical vapor deposition" (PVD) oder durch Sputtern erfolgen. Ist das Substrat ein biegbares Material, kann diese Beschichtung auch kontinuierlich erfolgen, durch Behandeln von Rollenware.

Auf der reflektierenden Oberfläche befindet sich eine oder mehrere keramische Schichten bestehend aus einer Verbindung der Formel SiOₓ oder enthaltend eine Verbindung der Formel SiOₓ, wobei x eine Zahl von 1,5 bis 2,0, zweckmässig eine Zahl von 1,5 bis 1,9 und bevorzugt eine Zahl von 1,5 bis 1,8, bedeutet. Solche keramische Schichten sind niedrig brechend, vorzugsweise mit einem Brechungsindex von kleiner als 1,6. Die keramischen Schichten sind erhältlich beispielsweise durch Verfahren der Vakuumdünnschichttechnik, zweckmässig auf der Basis von Elektronenstrahlverdampfen oder Widerstandsheizen oder induktivem Heizen von zu verdampfenden Materialien; bekannt z.B. als Aufdampfmaterial, Targetmaterialien oder Targets. Bevorzugt ist das Elektronenstrahlverdampfen. Die beschriebenen Verfahren können reaktiv und/oder mit lonenunterstützung gefahren werden. Diese Verfahren werden derart ausgeführt, dass im Vakuum die zu verdampfenden Materialien aus z.B. Mischungen von Siliciumdioxid mit Silicium-Halbmetall als zu verdampfende Materialien im Vakuum einer Vakuukammer verdampft werden. In der Vakuumkammer schlägt sich eine keramische Schicht aus oder enthaltend die Verbindungen der Formel SiOₓ auf dem Substrat vollflächig nieder und bildet auf den Seiten des Substrates, die den verdampften Materialien ausgesetzt sind, die keramische Schicht. Die gewünschte Zahl x kann z.B. durch das stöchiometrische Verhältnis von SiO₂ zu Si oder SiO₂ zu Si und weiterer Zusätze, eingestellt werden. Die Mengenverhältnisse der sauerstoffhaltigen Verbindung SiO₂, zum Halbmetall Si können erfindungsgemäss stöchiometrisch einen Sauerstoffmangel von 10 bis 30%, bezogen auf das reine Oxid im abgedampften Material, ergeben.

Das erfindungsgemäße Verfahren ist in Anspruch 1 definiert. Bevorzugte Ausführungsformen sind in den Ansprüchen 2 bis 11 beansprucht. Gemäss dem Verfahren wird auf die reflektierenden Oberfläche mittels eines Vakuumdünnschichtverfahrens durch gleichzeitiges Verdampfen im Vakuum von Siliciumdioxid (SiO₂) und halbmetallischem Silicuium (Si) als aufzudampfendes Material, wenigstens eine 50 bis 2000 nm (Nanometer) dicke keramische Schicht bestehend aus oder enthaltend eine Verbindung der Formel SiOₓ, wobei x eine Zahl von 1,5 bis 2,0 bedeutet, niedergeschlagen und auf die freie Oberfläche der keramischen Schicht wird anschliessend eine für sichtbares Licht halbdurchlässige reflektierende Schicht eines Metalles in einer Dicke von 0,2 bis 60 nm (Nanometer) durch Sputtern aufgetragen.

Dem SiO₂ können als zu verdampfende Materialien weitere Zusätze, wie Al₂O₃, B₂O₃ und/oder MgO, in Mengen von beispielsweise bis zu 50 Mol-%, zweckmässig wenigstens 5 Mol-% und zweckmässig bis zu 30 Mol-%, jeweils bezogen auf das SiO₂, zugesetzt werden. Dem SiO₂ können auch als zu verdampfende Materialien weitere Zusätze, wie Al, B und/oder Mg, in reiner Form oder als eine Si-Legierung, enthaltend Al, B und/oder Mg, zugesetzt werden. Die Zusätze von Al, B und/oder Mg können in Mengen von beispielsweise bis zu 50 Mol-%, zweckmässig wenigstens 5 Mol-% und zweckmässig bis zu 30 Mol-%, jeweils bezogen auf das Si, zugesetzt werden. Die Mengenverhältnisse der sauerstoffhaltigen Verbindungen, wie SiO₂, Al₂O₃, B₂O₃ und MgO, zu den Metallen, resp. Halbmetallen, werden beispielsweise derart gewählt, dass sich stöchiometrisch ein Sauerstoffmangel von 10 bis 30%, bezogen auf die Summe der reinen Oxiden (SiO₂ und ev. Al₂O₃, B₂O₃ und/oder MgO) im abgedampften Material, ergibt

Das Beschichtungsverfahren wird über die Verdampfungsrate des Tiegelmaterials, die Abscheidungsrate auf dem Substrat und die Expositionsdauer des Substrates in der Vakuumkammeratmosphäre derart gesteuert, dass sich eine 50 nm (Nanometer) bis 2000 nm, zweckmässig 100 bis 1000 nm und vorzugsweise 150 bis 500 nm, dicke Schicht des keramischen Materials abgeschieden hat. Diese Schichtdicken definieren den erzielbaren Farbeffekt.

Auf die erste keramische Schicht kann vollflächig oder teilflächig eine zweite Schicht oder mehrere Schichten aus den genannten keramischen Materialien, z.B. aus oder enthaltend Verbindungen der allgemeinen Formel SiOₓ, jeweils jede Schicht in den für die erste keramische Schicht genannten Dicken, abgeschieden werden. Im Falle einer teilflächigen Abscheidung kann die zweite Schicht ein Muster, wie ein Logo, ein Schriftbild, ein Raster usw. darstellen. Durch die Reflexion der auftreffenden Strahlung durch unterschiedliche Schichtdicken hindurch können visuelle Effekte erreicht werden.

Über der oder den keramischen Schichten ist eine weitere Schicht eines Metalles in einer Dicke von 0,2 bis 60 nm (Nanometer), zweckmässig von 1 bis 40 nm und vorzugsweise von 2 bis 20 nm, angeordnet. Diese weitere Schicht ist für das sichtbare Licht halbdurchlässig reflektierend und besteht oder enthält beispielsweise ein oder mehrere der Metalle aus der Reihe der Edelstähle, Ni, Al, Cu, Ag, Au und vorzugsweise Cr. Die halbdurchlässige reflektierende Schicht eines Metalles kann beispielsweise durch ein weiteres Vakuumdünnschichtverfahren, wie oben beschrieben, mit einem der genannten Metalle als zu verdampfendes Material oder durch Sputtern mit einem der genannten Metalle als Target, aufgetragen werden. Das Target kann beispielsweise ein Metall, aus der Reihe der Edelstähle, Nickel, Aluminium, Kupfer, Silber, Gold und vorzugsweise Chrom oder Mischungen davon oder Legierungen davon enthalten oder aus genannten Metallen, Mischungen oder Legierungen bestehen. Bei dem erfindungsgemäßen, kontinuierlichen Beschichtungsprozess wird das Substrat in einer ersten Kammer zuerst mit der keramischen Schicht beaufschlagt, dann durch eine Spaltschleuse geleitet und anschliessend in einer weiteren Kammer durch Sputtern mit der halbdurchlässigen reflektierenden Metallschicht beaufschlagt.

Auf der genannten weiteren halbdurchlässig reflektierenden Schicht eines Metalles kann zusätzlich eine teilflächige Bedruckung mittels einer beliebigen Druckfarbe aufgebracht werden. Die Bedruckung kann ein Druckmuster sein, wie ein Logo, ein Schriftbild, ein Raster usw., in einer oder mehreren Farben, darstellen. Das Druckmuster darf, um die Wirkung des erfindungsgemässen Schichtsystemes zu ermöglichen, nur teilflächig aufgebracht sein.

In anderer oder zusätzlicher Weise kann zur Charakterisierung und fälschungssicheren Gestaltung der Verpackungen und Packmittel unmittelbar auf der reflektierenden Schicht des Substrates eine Bedruckung angebracht werden. Die Bedruckung unmittelbar auf der reflektierenden Oberfläche kann ein teilflächiges Druckmuster, wie ein Logo, ein Schriftbild, ein Raster usw., in einer oder mehreren Farben, mit der Massgabe, dass weisse Farbe ausgenommen ist, darstellen. Lasierende Druckfarben und Klarlacke sind besonders geeignet und bilden infolge geringen Pigment- oder Farbstoffgehaltes einen durchsichtigen oder durchscheinenden Überzug. Die Bedruckung unmittelbar auf der reflektierenden Oberfläche in einer vorzugsweise lasierenden Druckfarbe kann in einem oder in mehreren Farbtönen erfolgen und die Farbtöne entsprechen insbesondere den Farben, die durch das erfindungsgemässe Schichtsystem unter einem bestimmten Betrachtungswinkel erzeugt werden. Bei der Betrachtung der Verpackung oder des Packmittels unter dem bestimmten Betrachtungswinkel verschwindet für den Betrachter die Bedruckung, da die Farbe der Bedruckung und die Farbe, die sich durch die Reflexion des Lichtes durch die unterschiedlichen Schichten hindurch ergibt, gleich ist.

Die reflektierende Schicht kann auch auf chemischem Wege, wie durch Ätzen und dergl. mit einem Muster, wie ein Logo, ein Schriftbild, ein Raster usw., versehen werden. Die keramische Schicht kommt dann auf die Bedruckung oder dieses Ätzmuster zu liegen. Es ist auch möglich das Substrat, insbesondere ein metallfolienhaltiges Substrat vor oder nach dem Aufbringen der Schichten zu prägen, d.h. durch beispielsweise Prägewalzen oder Prägestempel ein Prägemuster, wie ein Logo, ein Schriftbild, ein Raster usw., am Substrat anzubringen. Es ist auch möglich, das Substrat, beispielsweise in Folienform vorliegend, vor oder nach der erfindungsgemässen Beschichtung, zu Formpackungen zu tiefen, z.B. durch Tiefziehen oder Streckziehen oder durch ein kombiniertes Verfahren aus Tief- und Streckziehen. Die Präge- und Tiefungsverfahren beeinflussen die Farbeffekte nicht oder nur wenig und die Farbeffekte bleiben somit erhalten.

Die bereits erwähnten Verfahren der Vakuumdünnschichttechnik auf der Basis von Elektronenstrahlverdampfen und des Sputterns können zur Beschichtung vorliegender Substrate weiter verfeinert werden. Über die kontinuierliche Messung des Reflexionsspektrums der beschichteten Substrate und damit der Farbe des Schichtsystems auf dem Substrat, kann die Leistung des Elektronenstrahles entsprechend erhöht oder gesenkt werden, bis die erforderliche Schichtdicke resp. Farbe erreicht ist. Die Steuerung kann durch einen geschlossenen Regelkreis erfolgen. Bei kontinuierlichen Verfahren kann fallweise auch über die Vorschubgeschwindigkeit des Substrates die Abscheidungsrate gesteuert werden. Das vorliegende Verfahren und die Wahl der beschriebenen Aufdampf- oder Targetmaterialien zur Erzeugung der Schichten aus den genannten keramischen Materialien ermöglichen beispielsweise hohe Durchlaufgeschwindigkeiten von bis zu 100 m/min bei der Beschichtung von bandförmigen Substraten, resp. Beschichtungsraten von bis zu 200 m²/min. Durch die Auswahl der Aufdampf- oder Targetmaterialien und die Erzeugung von keramischen Schichten aus oder enthaltend Verbindungen der allgemeinen Formel SiOₓ, wobei x die Bedeutung von 1,5 bis 2,0 hat, werden insbesondere klare und gelbstichfreie keramische Schichten erhalten. Durch den Si-, resp. Al-, B- oder Mg-Anteil in den zu verdampfenden Materialien wird die Bildung von Sauerstoff, der zur Erhaltung des Vakuums fortlaufend abgepumpt werden muss, vermindert. Dies führt insgesamt zu hohen Aufdampfraten.

Die erfindungsgemäss hergestellten Schichtfolgen können abschliessend, z.B. zum Schutz gegen Beschädigung, wie Abrieb od. dergl., mit einem Schutz-, Deck- oder Heisssiegellack oder mit einer insbesondere durchsichtigen Kunststofffolie oder -laminat oder einem Kunststoffextrudat überdeckt werden. Typische Folien, Laminate oder Extrudate enthalten beispielsweise Polyolefine, wie Polypropylen.

Die wie vorstehend behandelten Substrate können die erfindungsgemäss hergestellten Verpackungen oder Packhilfsmittel bilden. Beispielsweise können aus folienförmigen Substraten durch Ausstanzen und Siegeln beispielsweise Beutel, Sachets, Einwickler, Täschen usw. hergestellt werden. Folien können durch Tief- und /oder Streckziehen zu Formpackungen oder Formkörpern, wie Bodenteilen von Durchdrück- oder Blisterpackungen oder zu Weithalsgefässen, Menueschalen, Gobelets, Bechern usw. verformt werden. Es können aus den Folien z.B. Tuben (Laminattuben) oder Deckel für Formpackungen hergestellt werden. Aus beispielsweise kartonhaltigen Substraten können Schachteln, wie Faltschachteln, hergestellt werden. Es ist auch möglich, z.B. Flaschen, aus Kunststoffen geblasen, oder vorgeformte Formpackungen als Substrate zu verwenden und die erfindungsgemässen Schichtfolgen darauf anzubringen. Verschlüsse, Öffnungen, Nähte, Nähte zwischen einem Bodenteil und dem dazugehörigen Deckel usw. können mit einem erfindungsgemässen Packhilfsmittel in Form einer Etikette, eines Siegelstreifens, einer Banderole, eines Garantiesiegels oder einer Überschliessung versehen werden. Diese letzteren Packhilfsmittel liegen in der Regel in Folienform vor und werden auf dem entsprechenden Behälter über der Öffnung und am angrenzenden Behälterteil fixiert, wie beispielsweise festgeklebt, angeschweisst, aufgebördelt oder aufgeschrumpft usw. Das Packhilfsmittel weist den fälschungssicheren erfindungsgemässen Schichtaufbau auf. Dieser Schichtaufbau, fallweise unterstützt durch die Druck- und/oder Ätzmuster, führt zu einem beispielsweise marken- oder herstellertypischen Erkennungsbild auf dem Packhilfsmittel. Der Schichtaufbau führt zu der gezielt angestrebte Reflexion des einfallenden Lichtes und Farbverschiebung des ausfallenden Lichtes entsprechend dem Betrachtungswinkel. Eine Fälschung durch Fotokopieren des Packhilfsmittels und Verwendung der Fotokopie als Originalitäts- oder Herstellergarantie wäre sofort und leicht erkennbar, da jegliche Reflexion und Farbverschiebung ausbleibt. Damit die Packhilfsmittel, beispielsweise Siegelstreifen oder Banderolen, vom Verbraucher leichter gebrochen werden können, kann es zweckmässig sein, Anreisshilfen, wie Schwächungen, Kerbungen oder Abreisszungen vorzusehen. Es können als Substrate auch leicht einreissbare oder durchstossbare Folien, wie mit Füllstoffen angereicherte Kunststoffolien oder aus zwei schlecht verträglichen Kunststoffen hergestellte Folien, angewendet werden. Andere Substrate sind Schrumpffolien.

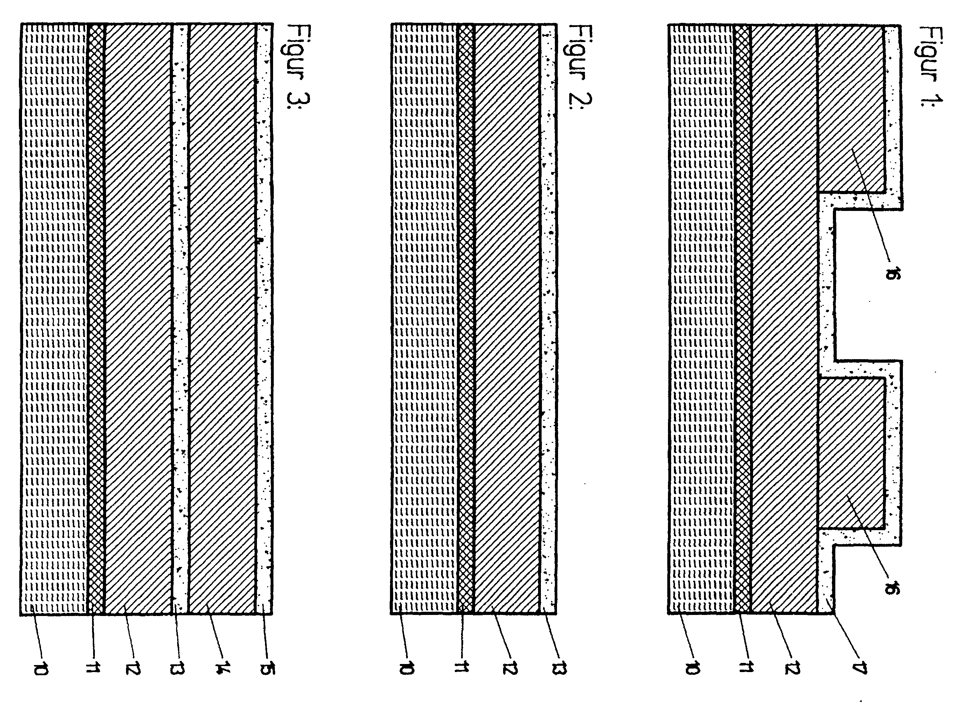

Die Figuren 1 bis 3 zeigen beispielhaft Schnitte durch die Schichtfolgen der erfindungsgemäß hergestellten Verpackungen oder Packhilfsmittel.

In Figur 1 ist ein Substrat (10), wie z.B. ein Laminat aus Kunststoffen, mit einer reflektierenden Oberfläche (11), beispielsweise mit einer durch Sputtern erzeugten reflektierenden Schicht, z.B. einer Aluminium-Schicht, bedeckt. Über der reflektierenden Oberfläche (11) ist die Schichtfolge angeordnet aus zwei Schichten (12,16) einer Verbindung der Formel SiOₓ, wobei x eine Zahl von 1,5 bis 2,0 bedeutet, jeweils in einer Dicke im Bereich von 50 bis 2000 nm (Nanometer), und über den freien Oberflächen der SiOₓ-Schichten (12,16) ist eine für elektromagnetische Strahlung im Bereich des sichtbaren Lichtes halbdurchlässige reflektierende Schicht (17) eines Metalles in einer Dicke von 0,2 bis 60 nm angeordnet. Die Schicht (16) einer Verbindung der Formel SiOₓ stellt eine nur teilflächige Abscheidung in Form eines Musters, wie eines Rasters, dar. In einer ersten Verfahrensstufe wird die Schicht (12) vollflächig abgeschieden und in einer zweiten Verfahrensstufe werden Teile der ersten Schicht (12) z.B. durch strukturiertes Aufdampfen von Oelen (wie aus der Herstellung von Kondensatorfolien bekannt) maskiert oder mittels einer Schablone usw. abgedeckt und die zweite Schicht (16) aufgedampft. Nach Entfernung der Abdeckung bleibt die Schicht (16) als Abbild der Zwischenräume der Abdeckung auf der ersten Schicht (12) zurück.

Gemäss Figur 2 weist ein Substrat (10), beispielsweise ein Laminat aus Kunststoffen, eine reflektierende Oberfläche (11) auf, beispielsweise eine durch Sputtern erzeugte reflektierende Schicht aus z.B. Aluminium. Über der reflektierenden Oberfläche (11) ist eine Schichtfolge vorhanden aus einer Schicht (12) einer Verbindung der Formel SiOₓ, wobei x eine Zahl von 1,5 bis 2,0 bedeutet, in einer Dicke im Bereich von 50 bis 2000 nm (Nanometer), und über der freien Oberfläche der SiOₓ-Schicht eine für elektromagnetische Strahlung im Bereich des sichtbaren Lichtes halbdurchlässige reflektierende Schicht (13) eines Metalles in einer Dicke von 0,2 bis 60 nm (Nanometer).

Gemäss Figur 3 ist ein Substrat (10), beispielsweise ein Laminat aus Kunststoffen, durch beispielsweise Sputtern, mit einer reflektierenden Schicht, z.B. einer Aluminium-Schicht, als reflektierende Oberfläche (11), bedeckt. Über der reflektierenden Oberfläche (11) ist zweimal die Schichtfolge vorhanden, enthaltend jeweils eine Schicht (12,14) einer Verbindung der Formel SiOₓ, wobei x eine Zahl von 1,5 bis 2,0 bedeutet, in einer Dicke im Bereich von 50 bis 2000 nm (Nanometer) und jeweils über der Oberfläche der SiOₓ-Schicht angeordnet, eine für elektromagnetische Strahlung im Bereich des sichtbaren Lichtes halbdurchlässige retlektierende Schicht (13,15) eines Metalles in einer Dicke von 0,2 bis 60 nm (Nanometer).

Anstelle der beispielhaft genannten Laminate können die andere der erwähnten Substrate beliebig angewendet werden. Wird ein Substrat (10) mit reflektierender Oberfläche (11) angewendet, kann sich die reflektierende Schicht erübrigen. Auf der freien Seite der obersten halbdurchlässigen reflektierenden Schicht (13,15,17) kann eine Bedruckung mit Druckfarben und/oder mehrere weitere Schichten, beispielsweise eine Folie oder ein Extrudat aus einem durchsichtigen Material, wie z.B. aus Polyethylen oder Polymere mit Ethyl-Acrylsäure (EAA), aufgebracht sein. Unmittelbar auf der reflektierenden Oberfläche (11), gegen die Schicht (12) gerichtet kann, wie oben erwähnt, eine Bedruckung mittels eines Klarlackes oder einer insbesondere lasierenden Druckfarbe angebracht sein. Die reflektierende Oberfläche (11) kann auch durch eine Prägung oder ein Ätzmuster gekennzeichnet sein.

## Patentansprüche

1. Verfahren zur Herstellung von Verpackungsmaterialien oder Packhilfsmitteln mit integrierter Erstöffnungs- oder Originalitätsgarantie, enthaltend ein Substrat (10) mit einer das sichtbare Licht reflektierenden Oberfläche (11) aus Metall,
**dadurch gekennzeichnet, dass**
auf die reflektierende Oberfläche (11) mittels eines Vakuumdünnschichtverfahrens durch gleichzeitiges Verdampfen im Vakuum von Siliciumdioxid (SiO₂) und halbmetallischem Silicium als zu verdampfende Materialien aus einer Aufdampfquelle wenigstens eine 50 bis 2000 nm (Nanometer) dicke keramische Schicht, enthaltend oder bestehend aus einer Verbindung der Formel SiOₓ, wobei x eine Zahl von 1,5 bis 2,0 bedeutet, niedergeschlagen wird und auf die freie Oberfläche der keramischen Schicht oder der keramischen Schichtfolge anschliessend eine für sichtbares Licht halbdurchlässige reflektierende Schicht eines Metalles in einer Dicke von 0,2 bis 60 nm durch Sputtern eines die entsprechenden Metalle enthaltenden Targets aufgetragen wird, und die Beschichtungsprozesse kontinuierlich ausgeführt werden, und das Substrat in einer ersten Kammer zuerst mit der keramischen Schicht beaufschlagt, dann durch eine Spaltschleuse geleitet und anschliessend in einer weiteren Kammer durch Sputtern mit der Metallschicht beaufschlagt wird.

2. Verfahren zur Herstellung von Verpackungsmaterialien oder Packhilfsmitteln nach Anspruch 1, **dadurch gekennzeichnet, dass** das Substrat (10) ein ein- oder mehrschichtiger Werkstoff und vorzugsweise ein flexibles, folienförmiges Material ist.

3. Verfahren zur Herstellung von Verpackungsmaterialien oder Packhilfsmitteln nach Anspruch 1, **dadurch gekennzeichnet, dass** die reflektierende Oberfläche (11) eine Metallschicht ist und die Metallschicht vorzugsweise Al, Cr, Ni, Au oder Ag oder Mischungen oder Legierungen davon enthält oder daraus besteht.

4. Verfahren zur Herstellung von Verpackungsmaterialien oder Packhilfsmitteln nach Anspruch 1, **dadurch gekennzeichnet, dass** eine erste keramische Schicht (12) die reflektierende Oberfläche (11) vollständig bedeckt und eine zweite oder eine zweite und weitere keramische Schichten (16) die erste keramische Schicht, vollflächig oder teilflächig als Muster bedecken.

5. Verfahren zur Herstellung von Verpackungsmaterialien oder Packhilfsmitteln nach Anspruch 1, **dadurch gekennzeichnet, dass** den zu verdampfenden Materialien weitere Zusätze, zweckmässig Al₂O₃, B₂O₃ und/oder MgO, in Mengen von bis zu 50 Mol-%, vorteilhaft wenigstens 5 Mol-% und zweckmässig bis zu 30 Mol-%, jeweils bezogen auf das SiO₂, zugesetzt werden.

6. Verfahren zur Herstellung von Verpackungsmaterialien oder Packhilfsmitteln nach Anspruch 1, **dadurch gekennzeichnet, dass** den zu verdampfenden Materialien weitere Zusätze, zweckmässig Al, B und/oder Mg, in reiner Form oder als eine Si-Legierung, enthaltend Al, B und/oder Mg, in Mengen bis zu 50 Mol-%, zweckmässig wenigstens 5 Mol-% und zweckmässig bis zu 30 Mol-%, jeweils bezogen auf das Si, zugesetzt werden.

7. Verfahren zur Herstellung von Verpackungsmaterialien oder Packhilfsmitteln nach Anspruch 1, **dadurch gekennzeichnet, dass** die Mengenverhältnisse der sauerstoffhaltigen Verbindung SiO₂, zum Halbmetall Si stöchiometrisch ein Sauerstoffmangel von 10 bis 30%, bezogen auf das reine Oxid im abgedampften Material, ergibt.

8. Verfahren zur Herstellung von Verpackungsmaterialien oder Packhilfsmitteln nach Ansprüchen 5 und 6, **dadurch gekennzeichnet, dass** die Mengenverhältnisse der sauerstoffilalfigen Verbindungen SiO₂, Al₂O₃, B₂O₃ und MgO, zu den Metallen, resp. Halbmetallen, Si, Al, B und Mg, stöchiometrisch ein Sauerstoffmangel von 10 bis 30%, bezogen auf die Summe der reinen Oxiden im abgedampften Material, ergeben.

9. Verfahren zur Herstellung von Verpackungsmaterialien oder Packhilfsmitteln nach Anspruch 1, **dadurch gekennzeichnet, dass** die durch Sputtern aufgebrachte Metallschicht Edelstahl, Nickel, Aluminium, Kupfer, Silber, Gold und vorzugsweise Chrom, oder Mischungen davon enthält oder daraus besteht.

10. Verfahren zur Herstellung von Verpackungsmaterialien oder Packhilfsmitteln nach Anspruch 1, **dadurch gekennzeichnet, dass** unmittelbar auf der reflektierenden Oberfläche eine Bedruckung in einer vorzugsweise lasierenden Druckfarbe in einem oder in mehreren Farbtönen aufgebracht wird und einzelne oder alle Farbtöne den Farben entsprechen, die durch das Schichtsystem der niedergeschlagenen Schichten unter einem bestimmten Betrachtungswinkel erzeugt werden und bei der Betrachtung der Verpackung oder des Packmittels, unter dem bestimmten Betrachtungswinkel, für den Betrachter die Bedruckung verschwindet, da die Farbe der Bedruckung und die Farbe, die sich durch die Reflexion des Lichtes durch die unterschiedlichen Schichten hindurch ergibt, gleich ist.

11. Verfahren zur Herstellung von Verpackungsmaterialien oder Packhilfsmitteln nach Anspruch 1, **dadurch gekennzeichnet, dass** das Substrat, insbesondere ein metallfolienhaltiges Substrat, vor oder nach dem Aufbringen der Schichten geprägt wird.

## Claims

1. Process for the production of packaging materials or packaging accessories with an integral guarantee of first opening or authenticity, containing a substrate (10) comprising a metal surface (11) reflecting visible light, **characterised in that** at least one 50 to 2000 nm (nanometres) thick ceramic layer containing or consisting of a compound having the formula SiOₓ, where x is a number from 1.5 to 2.0, is deposited on the reflecting surface (11) by means of thin-film vacuum deposition by the simultaneous evaporation in vacuo of silicon dioxide (SiO₂) and semimetallic silicon serving as the materials to be evaporated from an evaporation source, then a metal reflecting layer semi-transparent to visible light having a thickness of 0.2 to 60 nm is applied to the free surface of the ceramic layer or the sequence of ceramic layers by sputtering a target containing the corresponding metals, the coating processes are carried out continuously and the substrate is first provided with the ceramic layer in a first chamber, then passed through a slit-type lock and then provided with the metal layer in a further chamber by sputtering.

2. Process for the production of packaging materials or packaging accessories according to claim 1, **characterised in that** the substrate (10) is a single-layer or multi-layer material and preferably a flexible film material.

3. Process for the production of packaging materials or packaging accessories according to claim 1, **characterised in that** the reflecting surface (11) is a metal layer and the metal layer preferably contains or consists of Al, Cr, Ni, Au or Ag or mixtures or alloys thereof.

4. Process for the production of packaging materials or packaging accessories according to claim 1, **characterised in that** a first ceramic layer (12) completely covers the reflecting surface (11) and a second or a second and further ceramic layers (16) cover all or part of the surface of the first ceramic layer in the form of a pattern.

5. Process for the production of packaging materials or packaging accessories according to claim 1, **characterised in that** other additives, advantageously Al₂O₃, B₂O₃ and/or MgO, are added to the materials to be evaporated in quantities of up to 50 mole %, advantageously at least 5 mole % and expediently up to 30 mole %, in relation to SiO₂ in each case.

6. Process for the production of packaging materials or packaging accessories according to claim 1, **characterised in that** other additives, advantageously Al, B and/or Mg are added to the materials to be evaporated in pure form or in the form of an Si alloy containing Al, B and/or Mg in quantities of up to 50 mole %, advantageously at least 5 mole % and advantageously up to 30 mole %, in relation to Si in each case.

7. Process for the production of packaging materials or packaging accessories according to claim 1, **characterised in that** the relative proportions of the oxygen-containing compound SiO₂ and the semi-metal Si result stoichiometrically in an oxygen deficit of 10 to 30 % in relation to the pure oxide in the evaporated material.

8. Process for the production of packaging materials or packaging accessories according to claims 5 and 6, **characterised in that** the relative proportions of the oxygen-containing compounds SiO₂, Al₂O₃, B₂O₃ and MgO and the metals or semi-metals Si, Al, B and Mg result stoichiometrically in an oxygen deficit of 10 to 30 % in relation to-the sum of the pure oxides in the evaporated material.

9. Process for the production of packaging materials or packaging accessories according to claim 1, **characterised in that** the metal layer applied by sputtering contains or consists of stainless steel, nickel, aluminium, copper, silver, gold and preferably chromium or mixtures thereof.

10. Process for the production of packaging materials or packaging accessories according to claim 1, **characterised in that** printing in a preferably transparent ink in one or more colour tones is applied directly to the reflecting surface and one or all of the colour tones correspond to the colours produced by the layer system of the deposited layers when viewed at a specific angle and, when the package or packaging accessory is viewed at the specific angle, the printing disappears for the viewer, as the colour of the printing and the colour produced by the reflection of light through the different layers are the same.

11. Process for the production of packaging materials or packaging accessories according to claim 1, **characterised in that** the substrate, in particular a metal foil-containing substrate, is embossed before or after the application of the layers.

## Revendications

1. Procédé pour produire des matériaux d'emballage ou des moyens auxiliaires d'emballage présentant une garantie de première ouverture ou d'originalité, comportant un substrat (10) avec une surface (11) en métal réfléchissant la lumière visible, **caractérisé en ce que** l'on dépose sur la surface réfléchissante (11) une couche céramique d'une épaisseur d'au moins 50 à 2000 nm (nanomètres) au moyen d'un procédé d'application de couche mince sous vide par évaporation sous vide simultanée d'oxyde de silicium (SiO₂) et du métalloïde silicium à titre de matériaux à évaporer à partir d'une source de métallisation sous vide, ladite couche contenant ou étant constituée par un composé de la formule SiOₓ, x étant un nombre de 1,5 à 2,0, et ensuite on applique sur la surface libre de la couche céramique ou à la suite de la succession de couches céramique une couche en métal réfléchissante semi-transparente pour la lumière visible et présentant une épaisseur de 0,2 à 60 nm par pulvérisation d'une cible contenant les métaux correspondants, **en ce que** l'on effectue les opérations de revêtement en continu, et **en ce que** l'on sollicite le substrat dans une première chambre tout d'abord avec la couche céramique, puis on l'amène à travers un sas à fente et ensuite on le sollicite par pulvérisation avec la couche métallique dans une autre chambre.

2. Procédé pour produire des matériaux d'emballage ou des moyens auxiliaires d'emballage selon la revendication 1, **caractérisé en ce que** le substrat (10) est un matériau en une ou plusieurs couches et est de préférence un matériau flexible en forme de film.

3. Procédé pour produire des matériaux d'emballage ou des moyens auxiliaires d'emballage selon la revendication 1, **caractérisé en ce que** la surface réfléchissante (11) est une couche métallique, et **en ce que** la couche métallique contient ou est constituée de préférence de Al, Cr, Ni, Au ou Ag ou des mélanges ou alliages de ceux-ci.

4. Procédé pour produire des matériaux d'emballage ou des moyens auxiliaires d'emballage selon la revendication 1, **caractérisé en ce qu'**une première couche céramique (12) recouvre complètement la surface réfléchissante (11), et **en ce qu'**une deuxième couche ou une deuxième et d'autres couches céramiques (16) recouvre(nt) la première couche céramique complètement ou partiellement en formant un motif.

5. Procédé pour produire des matériaux d'emballage ou des moyens auxiliaires d'emballage selon la revendication 1, **caractérisé en ce que** l'on ajoute aux matériaux à évaporer d'autres additifs, judicieusement du Al₂O₃, B₂O₃ et/ou MgO, à des quantités allant jusqu'à 50 % en moles, avantageusement au moins 5 % en moles, et judicieusement jusqu'à 30 % en moles, respectivement par rapport au SiO₂.

6. Procédé pour produire des matériaux d'emballage ou des moyens auxiliaires d'emballage selon la revendication 1, **caractérisé en ce que** l'on ajoute aux matériaux à évaporer d'autres additifs, judicieusement du Al, B et/ou Mg, sous forme pure ou sous forme d'alliage Si contenant du Al, B et/ou Mg, à des quantités allant jusqu'à 50 % en moles, avantageusement au moins 5 % en moles, et judicieusement jusqu'à 30 % en moles, respectivement par rapport au Si.

7. Procédé pour produire des matériaux d'emballage ou des moyens auxiliaires d'emballage selon la revendication 1, **caractérisé en ce que** les rapports quantitatifs entre le composé SiO₂ contenant de l'oxygène et le métalloïde Si mènent stoechiométriquement à un manque d'oxygène de 10 à 30 %, en référence à l'oxyde pur dans le matériau évaporé.

8. Procédé pour produire des matériaux d'emballage ou des moyens auxiliaires d'emballage selon les revendications 5 et 6, **caractérisé en ce que** les rapports quantitatifs entre les composés contenant de l'oxygène SiO₂, Al₂O₃, B₂O₃ et MgO et les métaux ou métalloïdes, Si, Al, B et Mg mènent stoechiométriquement à un manque d'oxygène de 10 à 30 %, en référence à la somme des oxydes purs dans le matériau évaporé.

9. Procédé pour produire des matériaux d'emballage ou des moyens auxiliaires d'emballage selon la revendication 1, **caractérisé en ce que** la couche métallique appliquée par pulvérisation contient ou est constituée d'acier inoxydable, nickel, aluminium, cuivre, argent, or et de préférence de chrome, ou des mélanges de ceux-ci.

10. Procédé pour produire des matériaux d'emballage ou des moyens auxiliaires d'emballage selon la revendication 1, **caractérisé en ce que** l'on applique directement sur la surface réfléchissante une impression en une couleur d'impression de préférence vernissant avec une ou plusieurs nuances de couleurs, et **en ce que** des nuances de couleur individuelles ou toutes les nuances correspondent aux couleurs qui sont générées par le système des couches déposées sous un angle d'observation déterminé, et **en ce que** lors d'une observation de l'emballage ou du moyen d'emballage sous l'angle d'observation déterminé, l'impression disparaît pour l'observateur, car la couleur de l'impression et la couleur qui résulte par la réflexion de la lumière à travers les couches différentes sont égales.

11. Procédé pour produire des matériaux d'emballage ou des moyens auxiliaires d'emballage selon la revendication 1, **caractérisé en ce que** l'on applique une empreinte sur le substrat, en particulier un substrat contenant un film métallique avant ou après l'application des couches.
